# EUROPÄISCHE PATENTSCHRIFT

(11) **EP 2 291 263 B1**
(45) Veröffentlichungstag und Bekanntmachung des Hinweises auf die Patenterteilung: **28.02.2018**
(21) Anmeldenummer: 09772005.6
(22) Anmeldetag: 29.06.2009
(51) Int. Cl.: H01L 31/18, H01L 31/048, B24B 9/20

(54) **VERFAHREN UND VORRICHTUNG ZUM BESÄUMEN PHOTOVOLTAISCHER MODULE**
METHOD AND DEVICE FOR CHAMFERING PHOTOVOLTAIC MODULES
MÉTHODE ET DISPOSITIF DE CHANFREINAGE POUR MODULES PHOTOVOLTAÏQUES

(30) Priorität: 01.07.2008 DE 102008031061
(43) Veröffentlichungstag der Anmeldung: 09.03.2011
(73) Patentinhaber: Grenzebach Maschinenbau GmbH, 86663 Asbach-Bäumenheim (DE)
(72) Erfinder: STRASS, Manfred, 86655 Harburg (DE)
(74) Vertreter: Kindermann, Peter
(86) Internationale Anmeldenummer: PCT/DE2009/000909
(87) Internationale Veröffentlichungsnummer: WO 2010/000235

(56) Entgegenhaltungen:
- EP-A1- 1 166 961
- EP-A1- 1 733 843
- CN-A- 101 332 578
- JP-A- 8 197 402
- JP-A- 2006 026 787

## Beschreibung

Die Erfindung betrifft eine Vorrichtung und ein Verfahren zum automatischen Besäumen eines rechteckigen photovoltaischen Moduls mit zwei Längsseiten und zwei Querseiten, bestehend aus zwei aufeinander liegenden, gleich großen, Glasplatten mit einer Zwischenlage aus einer, die Glasplatten auf allen Seiten überlappenden, Folie.

Moderne Glasfassaden sind vielfach nicht nur ein Funktionselement eines Baukörpers, sondern dienen zunehmend auch zur solaren Stromerzeugung. Maßgeschneiderte Solarmodule ermöglichen die passgenaue Integration in Bauwerksraster und Profile. Semitransparente Solarzellen, aber auch opake Solarzellen mit transparenten Bereichen, lassen Photovoltaik - Verglasungen lichtdurchflutet erscheinen. Die Solarzellen übernehmen dabei häufig den gewünschten Effekt des Sonnen - und Blendschutzes.

Die Herstellung von solchen Photovoltaik - Anlagen erfordert Arbeitsbedingungen wie sie vor allem bei der Herstellung von Halbleitern und integrierten elektronischen Schaltungen üblich sind. Diese so genannten Reinraum - Bedingungen machen bei der Herstellung von Photovoltaik - Anlagen auch zusätzlich die Handhabung flächenmäßig großer stoßempfindlicher Glasplatten erforderlich.

Zur sicheren Handhabung solcher Glasplatten ist es erforderlich, die bei der Herstellung von so genannten photovoltaischen Modulen zwischen zwei Glasplatten befindliche, an den Rändern überstehende, Folie maßgerecht abzuschneiden. Bei einem photovoltaischen Modul handelt es sich, von außen betrachtet, um die Verbindung einer Substratplatte aus Glas, eines photovoltaischen Elements und einer Glasplatte als Deckglas mittels einer, unter Wärmeeinwirkung diese Glasplatten verklebenden, Folie.

Aus der DE 10 2004 030 411 A1 ist ein solches photovoltaisches Element, ein Solarmodul als Verbundsicherheitsglas bekannt geworden. Hierbei werden Solarmodule mit den Eigenschaften von Verbundsicherheitsverglasungen unter Verwendung von Folien auf Basis von Polyvinylbutyral (PVB) bereitgestellt, wobei mindestens eine der auf PVB basierenden Folien eine Reißfestigkeit von mindestens 16 N/mm² aufweist. Wie eine solche Folie bei dem, aus Gründen der Justierung, bei der Herstellung bedingten Überstand abzuschneiden ist, ist dieser Druckschrift nicht zu entnehmen.

Aus der DE 10 2005 027 964 A1 ist ein Verfahren und eine Vorrichtung zum Entfernen des Kunststofffolienüberstandes bei Verbundglasplatten bekannt geworden. Hierbei wird es ermöglicht, den Kunststofffolienüberstand maschinell und damit nicht nur schneller und kostengünstiger sondern vor allem auch präziser zu entfernen, wobei der Kunstofffolienüberstand mittels mindestens eines rotierenden abrasiven Werkzeuges randscharf abgetragen wird.
Weiterhin zeigt diese Druckschrift eine Vorrichtung zum Entfernen des randseitigen Überstandes der Kunststofffolie zwischen den Scheiben einer Verbundglasplatte, wobei diese Vorrichtungeine Auflage- oder Abstützfläche für die Verbundglasplatte, ein Transportmittel zum linearen Bewegen der Verbundglasplatte auf oder entlang dieser Fläche, ein am Rand dieser Fläche ortsfest montiertes Werkzeug mit einer rotierenden abrasiven Scheibe, die mit einer Umfangsfläche einen Längsrand der Verbundglasplatte tangential berührt und einen rechtwinklig zur Transportvorrichtung (in Richtung der Querabmessung der Verbundglasplatte) verfahrbaren Schlitten, der ein zweites, gleichartiges Werkzeug trägt, aufweist. Eine erklärende Zeichnung ist dieser Veröffentlichung nicht beigefügt.
Im Wesentlichen wird in der DE 10 2005 027 964 A1 die Verwendung eines abrasiven rotierenden Werkzeugs zum Entfernen des Kunstofffolienüberstandes vorgeschlagen und die Verwendung eines solchen Werkzeugs ortsfest an einer Längsseite und verfahrbar an einer Querseite. Die besonderen technischen Anforderungen bei der Realisierung dieser skizzierten Maßnahme in einer automatisch arbeitenden Anlage, zu berücksichtigende technische Randbedingungen und die Anforderungen bei schnellen Taktzeiten werden in dieser Druckschrift nicht angesprochen.

In der Druckschrift EP 1 166 961 A1 ist eine Vorrichtung zum automatischen Besäumen einer rechteckigen Glasplatte mit zwei Längsseiten und zwei Querseiten offenbart, mit den folgenden Merkmalen:
a) eine Detektionsvorrichtung (30) zum Detektieren der vorderen Kante einer in horizontaler Lage einfahrenden Glasplatte,
b) eine Vorrichtung zur Positionierung der Rückkante der Glasplatte in der Ausgangsposition,
c) Mittel zum vertikalen Anpassen (6) aller Schneideinrichtungen an die Glasdicke der jeweiligen Glasplatte,
d) Haltemittel zum Fixieren der hinteren Querseite der Glasplatte,
e) Mittel zum kantengenauen Abschneiden der überlappenden Kante der Glasplatte auf der hinteren Querseite,
f) Mittel zum Verfahren der Glasplatte in den Bereich zweier Längsschneide - Einrichtungen,
g) Haltemittel zum Fixieren der beiden Längsseiten der Glasplatte,
h) Mittel zum kantengenauen gleichzeitigen Abschneiden der überlappenden Kante der Glasplatte auf den beiden Längsseiten,
i) Mittel zum Verfahren der Glasplatte in den Bereich einer vorderen Querschneideeinrichtung,
j) Haltemittel zum Fixieren der vorderen Querseite der Glasplatte,
k) Mittel zum kantengenauen Abschneiden der überlappenden Kante der Glasplatte auf der vorderen Querseite,
l) Mittel zum Verfahren der besäumten Glasplatte zur weiteren Bearbeitung.

Aus der EP 1 733 843 A1 sind ein Verfahren und eine Vorrichtung zum Entfernen des randseitigen Überstandes der Kunststofffolie zwischen den Scheiben einer Verbundglasplatte bekannt, wobei der Kunststoffüberstand mittels mindestens einer rotierenden abrasiven Schleifscheibe randscharf abgetragen wird.

Der vorliegenden Erfindung liegt deshalb die Aufgabe zugrunde, eine Vorrichtung und ein Verfahren anzugeben, womit die Besäumung eines photovoltaischen Moduls, das heißt das Abtrennen überflüssiger Kunststofffolie, automatisch gesteuert, zuverlässig und mit niedrigen Taktzeiten preiswert auf allen Seiten gewährleistet werden kann.

Diese Aufgabe wird hinsichtlich der Vorrichtung durch die Merkmale des Anspruchs 1 und bezüglich des Verfahrens durch die Maßnahmen des Anspruchs 3 gelöst.

In den Unteransprüchen sind weiter vorteilhafte Ausführungsbeispiele der Erfindung gekennzeichnet.

Die erfindungsgemäße Vorrichtung wird im Folgenden näher beschrieben. Es zeigen im Einzelnen:
- Fig.1 :: eine perspektivische Darstellung der erfindungsgemäßen Vorrichtung
- Fig.2:: eine Draufsicht aus dem Bereich der Schneideinrichtungen
- Fig.3:: eine Draufsicht aus dem Bereich der Fixiervorrichtungen
- Fig.4:: eine perspektivische Darstellung eines Schneidkopfes
- Fig.5:: eine perspektivische Darstellung aus dem Bereich der vorderen querseitigen Fixiereinrichtung Fig.6: eine perspektivische Darstellung des rechten Schneidkopfes

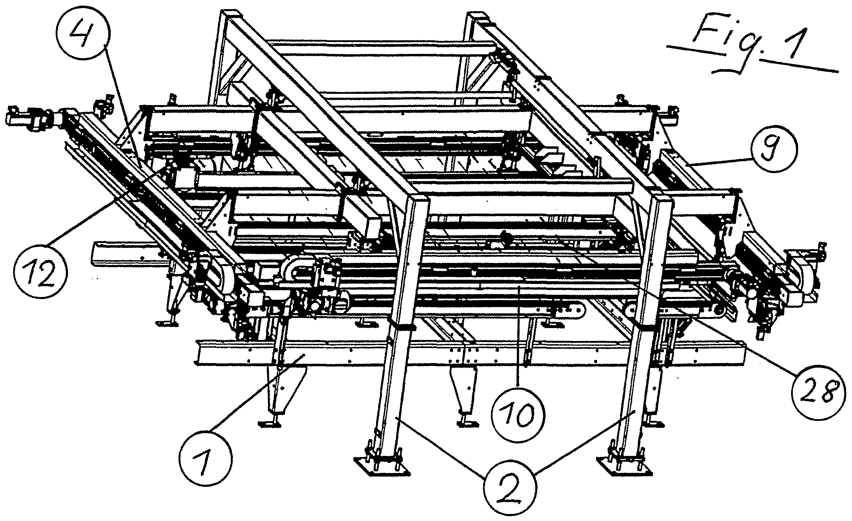

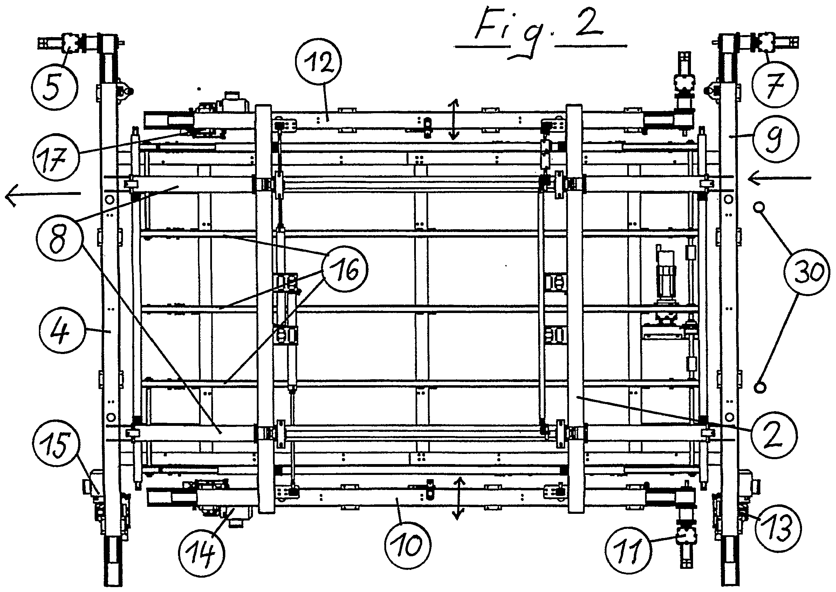

Fig.1 zeigt eine perspektivische Darstellung der Besäumungsvorrichtung im Zuge des Fertigungsprozesses eines photovoltaischen Moduls (28). Der Pfeil auf der rechten Seite der entsprechenden Fig.2 deutet die Richtung des Einlaufs eines zu
besäumenden Moduls (28) an. Entsprechend zeigt der Pfeil auf der linken Seite in die Richtung des Weges zur weiteren Bearbeitung eines Moduls (28). Ein photovoltaisches Modul (28) besteht, bei äußerer Betrachtung, im Wesentlichen aus zwei gleich großen, rechteckigen, aufeinander liegenden, Glasplatten mit einer Zwischenlage aus einer, die Glasplatten auf allen Seiten überlappenden, Folie. Der Zweck der erfindungsgemäßen Vorrichtung besteht darin, die überlappende Folie an den Kanten der Glasplatten automatisch sauber und genau abzutrennen. Im Folgenden soll ein solches photovoltaisches Modul (28) nur noch Modul (28) genannt werden.
Mit (2) sind in dieser Figur die Portalträger für die vordere und die hintere Folien - Querschneideeinrichtungen bezeichnet.
Auf der linken Seite ist die vordere Laufschienentraverse (4) und auf der rechten Seite die hintere Laufschienentraverse (9) der entsprechenden Querschneider gezeigt. Hier wird darauf hingewiesen, dass die Begriffe "vorne" oder "hinten"sich auf die Laufrichtung eines Moduls (28) während des Vorgangs des Besäumens beziehen. "Vorne" bezieht sich somit in der Fig.1 auf die linke Bildseite, "hinten" auf die rechte Bildseite. Ebenso bezieht sich der Begriff "links" in Bezug auf die beiden Längsschneid - Einrichtungen, in der Laufrichtung eines Moduls (28) betrachtet, auf die dem Betrachter zugewandte Seite, also die vordere Seite der Besäumungsvorrichtung der Fig.1. Entsprechend meint der Begriff "rechts" die hintere Seite der Besäumungsvorrichtung, also die dem Betrachter abgewandte Seite in der Fig.1.

Mit (12) ist die rechte Laufschiene der Längsschneid - Einrichtung, die sich entlang der Laufrichtung eines Moduls (28), das in der Mitte verdeckt zu erkennen ist, auf der dem Betrachter abgewandten Seite erstreckt, bezeichnet. Auf der anderen Seite der Besäumungsvorrichtung ist die linke Laufschiene (10) der Längsschneid - Einrichtung, dem Betrachter zugewandt, dargestellt.

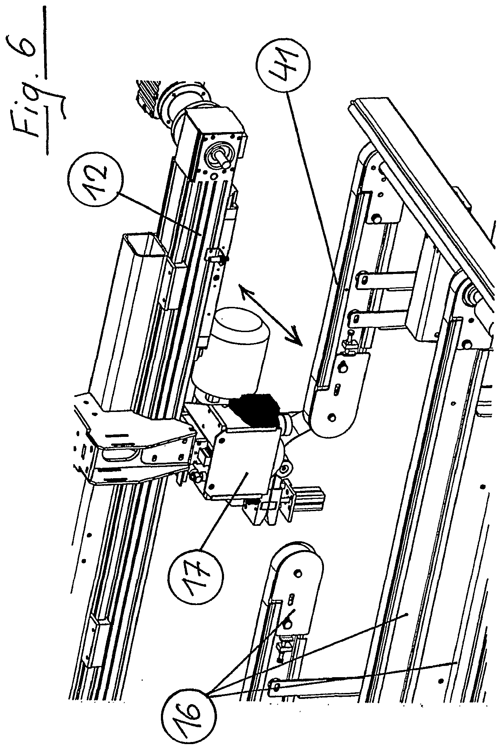

Die Fig. 2 zeigt eine Draufsicht aus dem Bereich der Schneideinrichtungen. Als herausragenste Merkmale sind in der Fig.2 die, schon bei der Beschreibung der Fig.1 erwähnten, hintere Laufschienentraverse (9) und die vordere Laufschienentraverse (4) zu erkennen, die beide über die beiden Längsholme (8) der Querschneideinrichtung verbunden sind. Die hintere Laufschienentraverse (9) trägt hier den Antrieb (7), der das Entlangfahren des hinteren Schneidkopfs (13) an dieser Traverse ermöglicht. Entsprechend ermöglicht der Antrieb (5) das Entlangfahren des vorderen Schneidkopfs (15) an der Laufschienentraverse (4). Die aus der Beschreibung der Fig. 1 bekannten, linken und rechten, Laufschienen ( 10) und (12) der Längsschneid - Einrichtung sind in der Fig.2, jeweils in der Mitte mit einem Doppelpfeil versehen, dargestellt. Hierdurch soll an dieser Stelle schon darauf hingewiesen werden, dass diese Laufschienen (10, 12) in ihrem parallelen Abstand zueinander, entsprechend dem jeweils zu besäumenden Querformat eines Moduls (28), verstellt werden können. (Vgl. hierzu auch Fig.6)
An der linken Laufschiene (10) ist der linke Schneidkopf (14) der Längsschneid - Einrichtung befestigt, entsprechend trägt die Laufschiene (12) den rechten Schneidkopf (17). Auf der rechten Seite der Fig. 2 ist in der unteren Ecke der Antrieb (11) für das, bzw. die Transportbänder (16) gezeigt. Der Portalträger (2) für die Querschneideinrichtung ist in der Fig.2 ebenfalls zu erkennen.
Die Sensoren (30) für die Detektierung der Position eines Moduls (28) sind im Bereich der hinteren Laufschienentraverse (9) dargestellt. Sie ermöglichen nicht nur das präzise Bestimmen der vorderen Kante eines einlaufenden Moduls (28), sondern können auch feststellen, ob diese Kante im rechten Winkel zur Längsrichtung der Besäumungsvorrichtung verläuft oder hiervon abweicht. Eine Erhöhung der Anzahl und / oder des Abstands solcher Sensoren (30) erhöht die Genauigkeit einer derartigen Messung.
Weiter können die Sensoren (30) die Position der hinteren Kante eines Moduls (28 ) erfassen. Aus dem Laufzeitunterschied der Erfassung dieser beiden Kanten kann die Länge des Moduls (28) berechnet werden. Es können jedoch zu diesem Zweck auch andere, dem Fachmann geläufige, Sensoren verwendet werden.

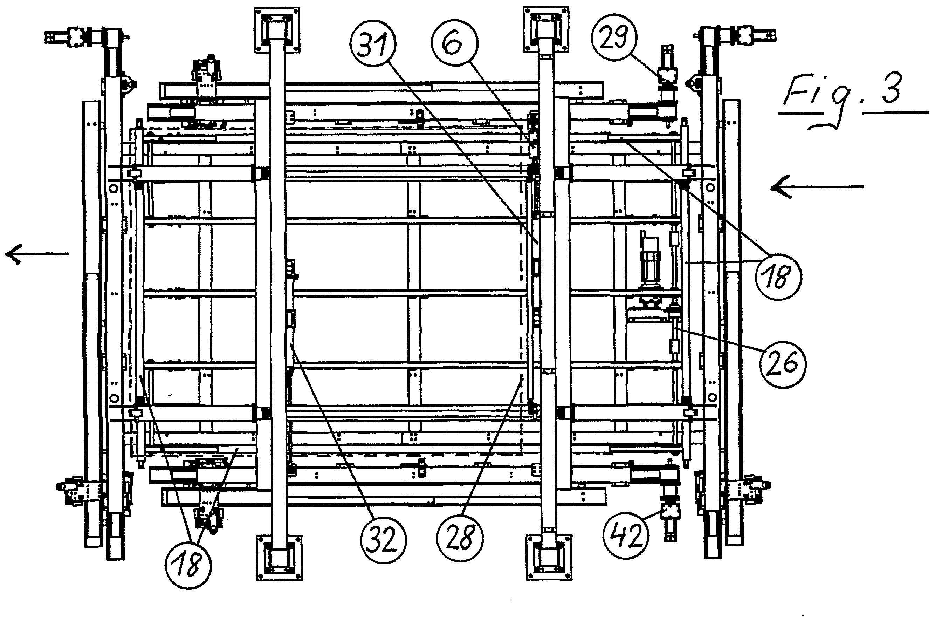

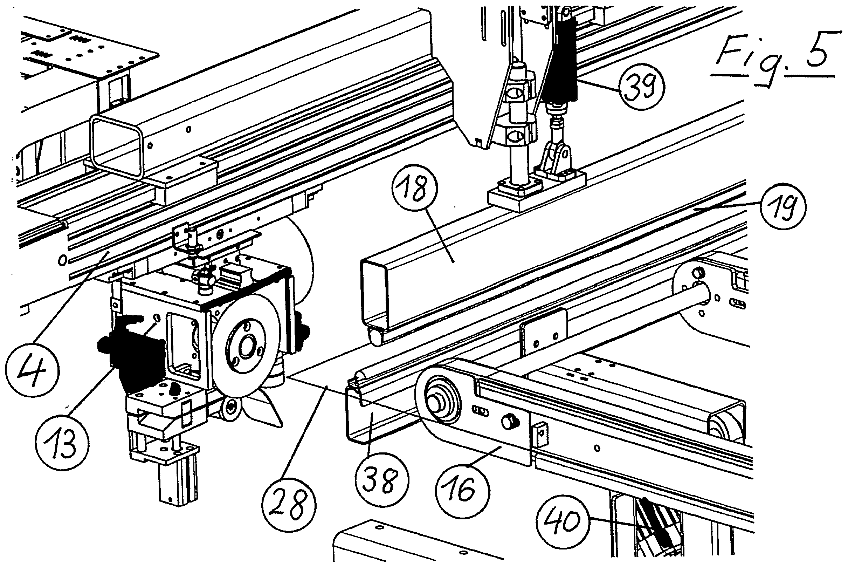

In der Fig. 3 ist eine Draufsicht aus dem Bereich der Fixiervorrichtungen dargestellt. Mit (29) und (42) sind hier die gegenüber liegenden Antriebe für die rechte und die linke Längsschneideinrichtung zu erkennen.
Die Träger (18), auf der linken wie auf der rechten Seite je zweimal gekennzeichnet, für die obere Modul - Fixiereinrichtung sind in dieser Ansicht ebenfalls zu sehen. Sie sind für die Querschneideeinrichtungen und die Längsschneideeinrichtungen mit derselben Zahl gekennzeichnet, da sie jeweils dieselbe Wirkung haben, nämlich das Modul (28) auf den jeweiligen Seiten über das, hier nicht erkennbare, Andruckmittel (19) an die Unterlage zu pressen. Auf diese Weise soll verhindert werden, dass sich die beiden Glasplatten eines Moduls während des Abtrennvorgangs der dazwischen liegenden Folie gegenseitig verschieben. Zur näheren Darstellung einer Fixiereinrichtung wird auf die Fig.5 verwiesen. In dieser Darstellung der Fig.3 sind der linke Querverstellungsantrieb (32) der Längsschneideeinrichtung und der rechte Querverstellungsantrieb (31) der Längsschneideeinrichtung im mittleren Bereich der Besäumungsvorrichtung, in dem ein Modul (28) gezeigt ist, gut zu erkennen. Wie schon bei der Beschreibung der Fig.2 bemerkt, dienen diese dazu, den Abstand der beiden Längsschneideeinrichtungen an die Breite des jeweiligen Moduls automatisch anzupassen.
Mit (6) ist der Antrieb für die gleichzeitige Vertikalbewegung der Querschneideinrichtung und der Längsschneideinrichtung bezeichnet. Diese ist notwendig um den Schneidvorgang insgesamt an unterschiedliche Glasdicken anzupassen. Dieser Vorgang kann ebenfalls automatisch ablaufen. Die Messung der jeweiligen Glasdicken der Module (28) erfolgt über Sensoren, deren Auswahl dem Fachmann überlassen bleibt und die aus Gründen der Übersichtlichkeit nicht extra dargestellt sind. Die Ausgangssignale dieser Sensoren stehen dem Steuerungsprogramm zur Verfügung.

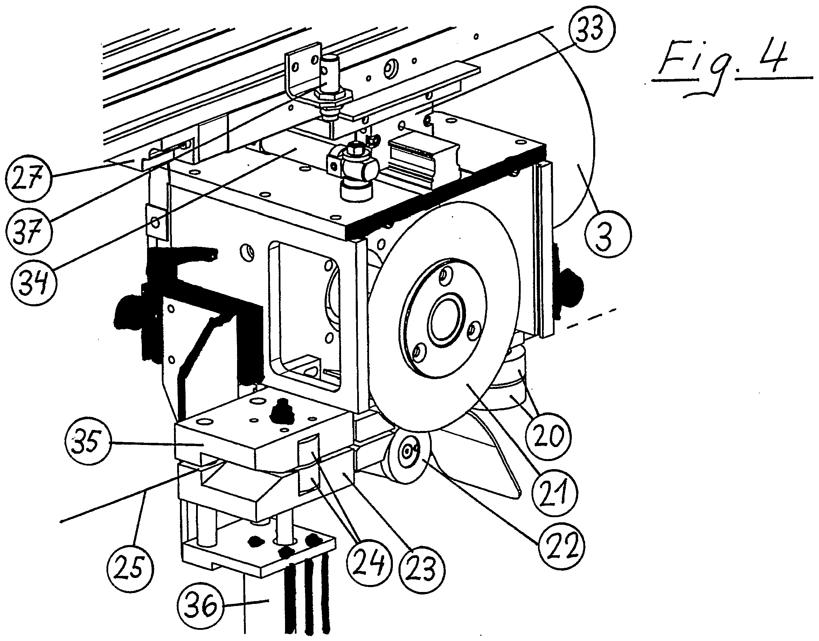

In der Fig.4 ist die perspektivische Darstellung eines der insgesamt vier, für alle vier Seiten eines Moduls (28) verwendeten, Schneidköpfe gezeigt.
Der Antrieb (3), hier in seiner äußeren Umrandung erkennbar, bewirkt die Drehung der Messerscheibe (21) und erzwingt zusammen mit dem Schneidrad (22) und dem Vortrieb des Schneidkopfs die Abtrennung der jeweiligen überlappenden Folie. Die Gleitrollen (24) für die vordere Folienführung gewährleisten im Verbund mit der hinteren Folienführung (20) den Anschlag für ein beständiges, in seinem Abstand zu den Glaskanten eines Moduls (28) definiertes, Anliegen eines Schneidkopfes während des Schneidvorgangs. Um die Einführung einer Folie in den Arbeitsbereich eines Schneidkopfs vor dem Beginn eines Schneidvorgangs sicherzustellen, werden die Gleitrollen (24) für die vordere Folienführung und die Rollen (20) für die hintere Folienführung gemeinsam auseinander geklappt. Dieser Vorgang erfolgt durch den Antriebszylinder (36) der das untere Lager (23) für die vordere Folienführung, die mechanisch mit der unteren Rolle (20) verbunden ist, vertikal verfahren kann. Die Außenkante einer entsprechenden Folie ist mit (25) bezeichnet, das ortsfeste obere Lager der Folienführung weist die Nummer (35) auf. Der Andruckzylinder (34) sorgt mittels der Verschiebeeinrichtung (33) für einen bestimmten Anpressdruck des Schneidkopfs an ein Modul (28).
Zur Ermittlung der exakten Position eines Schneidkopfes für das Steuerprogramm der Besäumungsvorrichtung dient ein Sensor (37). Seine Ausgangssignale werden für das Steuerprogramm der Besäumungsanlage erfasst und ausgewertet.

In der Fig.5 ist eine perspektivische Darstellung beispielhaft aus dem Bereich der vorderen querseitigen Fixiereinrichtung gezeigt. An der vorderen Laufschienentraverse (4) ist der vordere Schneidkopf (13) in einer Position, bzw. zu einem Zeitpunkt, gezeigt da der Träger (18) der oberen Fixiereinrichtung von dem oberen Antrieb (39) mittels des Andruckmittels (19) auf ein Modul (28) gedrückt wird, wobei das Modul (28) von unten über den unteren Antrieb (40) und die untere Fixiereinrichtung (38) nach oben gedrückt wird.

In der Fig.6 ist eine Verlängerung des Transportbands (16) durch ein kurzes Transportband (41) dargestellt. Diese so entstehende Lücke im Transportband (16 ) ermöglicht das "Durchfahren" des beispielhaft gezeigten rechten Schneidkopfs ( 17) durch das Transportband (16) bei einer notwendigen Verstellung der rechten Laufschiene (12) der Längsschneid - Einrichtung in Richtung des gezeigten Doppelpfeils. Eine solche Verstellung wird notwendig bei einer Umstellung der Besäumungsvorrichtung auf ein anderes Format (vgl. hierzu auch die Fig.2).

Um eine saubere Abtrennung der Folie zu gewährleisten und ein Abreißen oder ein Einreißen zu verhindern wird der Vortrieb der Schneidköpfe vor der Beendigung des Schneidvorgangs um ein bestimmtes Maß abgebremst. Ergebnisse von Vorversuchen mit unterschiedlichen Glasdicken und unterschiedlichen Folienarten und Foliendicken gehen als Betriebsparameter in das Steuerprogramm der Anlage ein. Ebenso ist das Programm in der Lage, unterschiedliche Formate von Modulen mittels entsprechender Sensoren zu erfassen und durch automatische Verstellung der Längsschneideeinrichtung und errechnete Werte auf die veränderten Vorschubwege und Vorschubgeschwindigkeiten der Schneidköpfe automatisch zu reagieren.

### Bezugszeichenliste

- (1): Grundrahmen
- (2): Portalträger für Folien - Querschneideinrichtung
- (3): Schneidkopfantrieb (Messerscheibe)
- (4): vordere Laufschienentraverse (Querschneider)
- (5): Antrieb für die vordere Querschneideinrichtung
- (6): Antrieb für die Vertikalbewegung der Querschneideinrichtungen und der Längsschneideinrichtungen
- (7): Antrieb für die hintere Querschneideinrichtung
- (8): Längsholme der Querschneideinrichtung
- (9): hintere Laufschienentraverse (Querschneider)
- (10): linke Laufschiene der Längsschneid - Einrichtung
- (11): Antrieb für Laufband
- (12): rechte Laufschiene der Längsschneid - Einrichtung
- (13): hinterer Schneidkopf (Querrichtung)
- (14): linker Schneidkopf (Längsrichtung)
- (15): vorderer Schneidkopf (Querrichtung)
- (16): Transportband für das photovoltaische Modul
- (17): rechter Schneidkopf (Längsrichtung)
- (18): obere Modul - Fixiereinrichtung (Träger)
- (19): obere Modul - Fixiereinrichtung (Andruckmittel)
- (20): hintere Folienführung
- (21): Messerscheibe
- (22): Schneidrad
- (23): unteres Lager für die vordere Folienführung (absenkbar)
- (24): Gleitrollen für die vordere Folienführung
- (25): Folien - Außenkante
- (26): Antriebsachse für Transportband
- (27): Schneidkopf - Schlitten
- (28): photovoltaisches Modul
- (29): Antrieb für rechte Längsschneideinrichtung
- (30): Sensoren für die Positionierung des photovoltaischen Moduls
- (31): rechter Querverstellungsantrieb (Längsschneideinrichtung)
- (32): linker Querverstellungsantrieb (Längsschneideinrichtung)
- (33): Verschiebeeinrichtung für Schneidkopf (Andruck Gleitrollen)
- (34): Andruckzylinder für Schneidkopf an das photovoltaische Modul
- (35): oberes Lager der Folienführung (fest)
- (36): Antriebszylinder für das Unterlager der Folienführung
- (37): Sensor für Schneidkopfposition
- (38): untere Fixiereinrichtung für das photovoltaische Modul
- (39): oberer Antrieb für die Fixiereinrichtung des photovoltaischen Moduls
- (40): unterer Antrieb für die Fixiereinrichtung des photovoltaischen Moduls
- (41): kurzes Transportband
- (42): Antrieb für linke Längsschneideinrichtung

## Patentansprüche

1. Vorrichtung zum automatischen Besäumen eines rechteckigen photovoltaischen Moduls (28) mit zwei Längsseiten und zwei Querseiten, im Wesentlichen bestehend aus zwei aufeinander liegenden, gleich großen, Glasplatten mit einer Zwischenlage aus einer, die Glasplatten auf allen Seiten überlappenden Folie, mit den folgenden Merkmalen:
a) eine Detektionsvorrichtung (30) zum Detektieren der vorderen Kante eines in horizontaler Lage einfahrenden Moduls (28),
b) eine Vorrichtung zur Positionierung der Rückkante des Moduls (28) in der Ausgangsposition,
c) Mittel zum vertikalen Anpassen (6) aller Schneideinrichtungen an die Glasdicke des jeweiligen Moduls (28),
d) Haltemittel zum Fixieren der hinteren Querseite (38, 39, 40) des Moduls (28),
e) Mittel zum kantengenauen Abschneiden (7, 13) der überlappenden Folie des Moduls (28) auf der hinteren Querseite,
f) Mittel zum Verfahren (11, 16) des Moduls (28) in den Bereich zweier Längsschneide - Einrichtungen,
g) Haltemittel zum Fixieren der beiden Längsseiten (38, 39, 40) des Moduls (28),
h) Mittel zum kantengenauen gleichzeitigen Abschneiden (42, 14, 29, 17) der überlappenden Folie des Moduls (28) auf den beiden Längsseiten,
i) Mittel zum Verfahren (11, 16) des Moduls (28) in den Bereich einer vorderen Querschneideeinrichtung,
j) Haltemittel zum Fixieren der vorderen Querseite (38, 39, 40) des Moduls (28),
k) Mittel zum kantengenauen Abschneiden (5, 15) der überlappenden Folie des Moduls (28) auf der vorderen Querseite,
l) Mittel zum Verfahren (11, 16) des besäumten Moduls zur weiteren Bearbeitung,
m) Vorrichtungen (31, 32) zur Anpassung der Längsschneideinrichtung an unterschiedliche Querformate von Modulen (28),
wobei Schneidköpfe (13, 14, 15, 17) der Mittel zum kantengenauen Abschneiden vor Beendigung des Schneidvorgangs definiert abgebremst werden können.

2. Vorrichtung nach Anspruch 1,
**dadurch gekennzeichnet,**
**dass** ein aus Erfahrungswerten generierter Speicher bei dem Vorliegen unterschiedlich gearteter Module und Folien zum Einsatz kommt, indem solche Unterschiede über Sensoren erfasst werden und bei der Steuerung des Vorgangs des Besäumens berücksichtigt werden.

3. Verfahren zum automatischen Besäumen eines rechteckigen photovoltaischen Moduls (28) mit zwei Längsseiten und zwei Querseiten, im Wesentlichen bestehend aus zwei aufeinander liegenden, gleich großen, Glasplatten mit einer Zwischenlage aus einer, die Glasplatten auf allen Seiten überlappenden Folie, mit den folgenden Merkmalen:
a) ein Modul (28) wird in horizontaler Lage in den Bereich einer Vorrichtung zum Besäumen verfahren, wobei die Position der vorderen Kante detektiert und erfasst wird,
b) das Modul (28) wird soweit verfahren bis sich die Rückkante in einer bestimmten definierten Ausgangsposition befindet,
c) dann wird die Glasdicke des betreffenden Moduls (28) ermittelt und die vertikale Anpassung (6) aller Schneidvorrichtungen an diese Glasdicke vorgenommen,
d) dann wird die hintere Querseite des Moduls (28) fixiert (38, 39, 40),
e) das Unterlager der Folienführung (36) wird vertikal nach unten verfahren, der entsprechende Schneidkopf herangefahren, das Unterlager wird wieder nach oben verfahren und der Schneidkopf an die Glaskante des Moduls (28) herangeführt,
f) der Schneidkopf wird mit der sich drehenden Messerscheibe an der hinteren Querseite entlang geführt und die überlappende Folie abgeschnitten,
g) das Modul (28) wird in den Bereich zweier Längsschneide-Einrichtungen verfahren (11, 16), auf beiden Längsseiten fixiert (38, 39, 40) und es werden gemäß den Merkmalen d) und e) auf beiden Längsseiten die überlappenden Folien abgeschnitten,
h) dann wird das Modul (28) in den Bereich der vorderen Querschneide-Einrichtung verfahren (11, 16), die vordere Querseite des Moduls (28) wird fixiert (38, 39, 40) und es wird gemäß den Merkmalen d) und e) die überlappende Folie abgeschnitten,
i) das besäumte Element wird zur weiteren Bearbeitung verfahren,
wobei Vorrichtungen (31, 32) zur Anpassung der Längsschneideinrichtung an unterschiedliche Querformate von Modulen (28) vorgesehen sind, und
wobei die Schneidköpfe vor Beenden des Schneidvorgangs definiert abgebremst werden können.

4. Verfahren nach Anspruch 3,
**dadurch gekennzeichnet,**
**dass** ein aus Erfahrungswerten generierter Speicher bei dem Vorliegen unterschiedlich gearteter Module und Folien zum Einsatz kommt, indem solche Unterschiede über Sensoren erfasst werden und bei der Steuerung des Vorgang des Besäumens berücksichtigt werden.

## Claims

1. Apparatus for automatically trimming a rectangular photovoltaic module (28) having two longitudinal sides and two transverse sides and consisting essentially of two glass plates of equal size which rest one on top of the other and have an intermediate layer comprising a film which overlaps the glass plates on all sides, said apparatus having the following features:
a) a detection apparatus (30) for detecting the front edge of a module (28) arriving in a horizontal position,
b) an apparatus for positioning the rear edge of the module (28) in the starting position,
c) means for vertically adapting (6) all the cutting devices to the glass thickness of the respective module (28),
d) holding means for fixing the rear transverse side (38, 39, 40) of the module (28),
e) means for cutting off (7, 13) the overlapping film of the module (28) with accurate edge alignment on the rear transverse side,
f) means for moving (11, 16) the module (28) into the region of two longitudinal cutting devices,
g) holding means for fixing the two longitudinal sides (38, 39, 40) of the module (28),
h) means for simultaneously cutting off (42, 14, 29, 17) the overlapping film of the module (28) with accurate edge alignment on both longitudinal sides,
i) means for moving (11, 16) the module (28) into the region of a front transverse cutting device,
j) holding means for fixing the front transverse side (38, 39, 40) of the module (28),
k) means for cutting off (5, 15) the overlapping film of the module (28) with accurate edge alignment on the front transverse side, and
l) means for moving (11, 16) the trimmed module for further processing,
m) apparatuses (31, 32) for adapting the longitudinal cutting device to different landscape formats of modules (28),
wherein cutting heads (13, 14, 15, 17) of the means for cutting off with accurate edge alignment can be decelerated in a defined manner before the end of the cutting operation.

2. Apparatus according to Claim 1,
**characterized**
**in that** a memory generated from empirical values is used if different modules and films are present, in that such differences are recorded via sensors and are taken into consideration for the control of the trimming operation.

3. Method for automatically trimming a rectangular photovoltaic module (28) having two longitudinal sides and two transverse sides and consisting essentially of two glass plates of equal size which rest one on top of the other and have an intermediate layer comprising a film which overlaps the glass plates on all sides, said method having the following features:
a) a module (28) is moved in a horizontal position into the region of a trimming apparatus, wherein the position of the front edge is detected and recorded,
b) the module (28) is moved until the rear edge is located in a specific, defined starting position,
c) the glass thickness of the module (28) in question is then determined and all the cutting apparatuses are vertically adapted (6) to said glass thickness,
d) the rear transverse side of the module (28) is then fixed (38, 39, 40),
e) the lower bearing of the film guide (36) is moved vertically downward, the corresponding cutting head is moved up, the lower bearing is moved upward again and the cutting head is guided up to the glass edge of the module (28),
f) the cutting head is guided together with the rotating cutting disk along the rear transverse side and the overlapping film is cut off,
g) the module (28) is moved into the region of two longitudinal cutting devices (11, 16), fixed on both longitudinal sides (38, 39, 40) and, according to features d) and e), the overlapping films are cut off on both longitudinal sides,
h) the module (28) is then moved into the region of the front transverse cutting device (11, 16), the front transverse side of the module (28) is fixed (38, 39, 40) and, according to features d) and e), the overlapping film is cut off, and
i) the trimmed element is moved for further processing,
wherein apparatuses (31, 32) for adapting the longitudinal cutting device to different landscape formats of modules (28) are provided, and
wherein the cutting heads can be decelerated in a defined manner before the end of the cutting operation.

4. Method according to Claim 3,
**characterized**
**in that** a memory generated from empirical values is used if different modules and films are present, in that such differences are recorded via sensors and are taken into consideration for the control of the trimming operation.

## Revendications

1. Dispositif de rognage automatique d'un module (28) photovoltaïque rectangulaire présentant deux côtés longitudinaux et deux côtés transversaux, essentiellement constitué de deux plaques de verre superposées de même taille ayant une couche intermédiaire constituée d'un film chevauchant les plaques de verre sur tous les côtés, comportant les éléments caractéristiques suivants :
a) un dispositif de détection (30) destiné à détecter le bord avant d'un module (28) introduit en position horizontale,
b) un dispositif destiné à positionner le bord arrière du module (28) à la position de départ,
c) des moyens destinés à adapter (6) verticalement tous les moyens de coupe à l'épaisseur de verre du module (28) respectif,
d) des moyens de maintien destinés à fixer le bord transversal arrière (38, 39, 40) du module (28),
e) des moyens destinés à effectuer une découpe (7, 13) alignée sur les bords du film à chevauchement du module (28) sur le côté transversal arrière,
f) des moyens destinés à déplacer (11, 16) le module (28) dans la région de deux moyens de coupe longitudinale,
g) des moyens de maintien destinés à fixer les deux côtés longitudinaux (38, 39, 40) du module (28),
h) des moyens destinés à effectuer une découpe (42, 14, 29, 17) simultanée alignée suivant les bords du film à chevauchement du module (28) sur les deux côtés longitudinaux,
i) des moyens destinés à déplacer (11, 16) le module (28) dans la région d'un moyen de coupe transversale avant,
j) des moyens destinés à fixer le côté transversal avant (38, 39, 40) du module (28),
k) des moyens destinés à effectuer une découpe (5, 15) alignée suivant les bords du film à chevauchement du module (28) sur le côté transversal avant,
l) des moyens destinés à déplacer (11, 16) le module rogné en vue d'un autre traitement,
m) des dispositifs (31, 32) destinés à adapter le moyen de coupe longitudinale à des formats transversaux différents des modules (28),
dans lequel des têtes de coupe (13, 14, 15, 17) peuvent être ralenties de manière définie pour effectuer une découpe alignée suivant les bords avant la fin du processus de coupe.

2. Dispositif selon la revendication 1, **caractérisé en ce qu'**une mémoire générée à partir de valeurs empiriques est mise en oeuvre lors de la présence de modules et de films de types différents en faisant en sorte que ces différences soient détectées par l'intermédiaire de capteurs et soient prises en compte lors de la commande du processus de rognage.

3. Procédé de rognage automatique d'un module (28) photovoltaïque rectangulaire présentant deux côtés longitudinaux et deux côtés transversaux, essentiellement constitué de deux plaques de verre superposées de même taille ayant une couche intermédiaire constituée d'un film chevauchant les plaques de verre sur tous les côtés, comportant les éléments caractéristiques suivants :
a) un module (28) est déplacé en position horizontale dans la région d'un dispositif de rognage, dans lequel la position du bord avant est détectée et acquise,
b) le module (28) est déplacé jusqu'à ce que le bord arrière se trouve à une position de départ déterminée définie,
c) l'épaisseur de verre du module (28) concerné est ensuite déterminée et l'adaptation verticale (6) de tous les dispositifs de coupe à ladite épaisseur est ensuite effectuée,
d) les côtés transversaux arrière du module (28) sont ensuite fixés (38, 39, 40),
e) le support inférieur du guide-film (36) est déplacé verticalement vers le bas, la tête de coupe correspondante est rapprochée, le support inférieur est de nouveau déplacé vers le haut et la tête de coupe est rapprochée du bord en verre du module (28),
f) la tête de coupe est guidée le long du côté transversal arrière avec le disque de coupe en rotation et le film à chevauchement est découpé,
g) le module (28) est déplacé dans la région de deux moyens de coupe longitudinaux (11, 16), est fixé sur les deux côtés longitudinaux (38, 39, 40) et les films à chevauchement sont découpés conformément aux éléments caractéristiques d) et e) sur les deux côtés longitudinaux,
h) le module (28) est ensuite déplacé (11, 16) dans la région du moyen de coupe transversale avant, le côté transversal avant du module (28) est fixé (38, 39, 40) et le film à chevauchement est découpé conformément aux éléments caractéristiques d) et e),
i) l'élément rogné est déplacé en vue d'un autre traitement,
dans lequel il est prévu des dispositifs (31, 32) destinés à adapter le moyen de coupe longitudinale à différents formats de modules (28), et dans lequel les têtes de coupe peuvent être ralenties de manière définie avant la fin du processus de coupe.

4. Procédé selon la revendication 3,
**caractérisé en ce qu'**une mémoire générée à partir de valeurs empiriques est mise en oeuvre lors de la présence de modules et de films de types différents en faisant en sorte que ces différences soient détectées par l'intermédiaire de capteurs et soient prises en compte lors de la commande du processus de rognage.
